# EUROPÄISCHE PATENTSCHRIFT

(11) **EP 3 899 563 B1**
(45) Veröffentlichungstag und Bekanntmachung des Hinweises auf die Patenterteilung: **07.02.2024**
(21) Anmeldenummer: 19821068.4
(22) Anmeldetag: 11.12.2019
(51) Int. Cl.: G01R 31/52, G01R 31/00

(54) **SCHALTUNGSVORRICHTUNG FÜR EIN FAHRZEUG UND VERFAHREN ZUM BETREIBEN EINER SCHALTUNGSVORRICHTUNG**
CIRCUIT DEVICE FOR A VEHICLE AND METHOD FOR OPERATING A CIRCUIT DEVICE
ENSEMBLE CIRCUIT POUR UN VÉHICULE, ET PROCÉDÉ DE FONCTIONNEMENT D'UN ENSEMBLE CIRCUIT

(30) Priorität: 19.12.2018 DE 102018132775
(43) Veröffentlichungstag der Anmeldung: 27.10.2021
(73) Patentinhaber: KNORR-BREMSE Systeme für Nutzfahrzeuge GmbH, 80809 München (DE)
(72) Erfinder: PRAMS, Stefan, 80637 München (DE)
(86) Internationale Anmeldenummer: PCT/EP2019/084706
(87) Internationale Veröffentlichungsnummer: WO 2020/126758

(56) Entgegenhaltungen:
- DE-A1-102005 046 282
- DE-A1-102008 052 467
- DE-B4-102008 052 467
- US-A1- 2015 022 153
- US-B2- 7 154 278

## Beschreibung

Der vorliegende Ansatz bezieht sich auf eine Schaltungsvorrichtung für ein Fahrzeug und auf ein Verfahren zum Betreiben einer Schaltungsvorrichtung.

Die DE 600 19 343 T2 offenbart ein elektrisches Kabel mit einer Erdungsplanschicht aus einem leitenden polymeren Material und einem Ableit-Leiter zur Erfassung eines Erdungsfehlers.

Die US 7 154 278 B2 offenbart eine Schaltungsanordnung zur Erkennung eines Leckstroms oder Fehlstroms. Die DE 10 2008 052467 A1 offenbart eine Leiterplatte mit einem isolierenden Material und Leiterbahnen sowie einem Sensor zum Überwa-chen eines Widerstandswerts des isolierenden Materials. Die DE 10 2005 046 282 A1 offenbart eine Vorrichtung zur Fehlerstromerkennung in einem elektrischen Gerät. Mittels eines Senseleiters wird im Fehlerfall eine Reduzierung der Isolationseigenschaften eines Isolationsmaterials erkannt. Die US 2015/0022153 A1 offenbart ein Gerät zum Erkennen eines Leckstroms.

Vor diesem Hintergrund ist es die Aufgabe des vorliegenden Ansatzes eine verbesserte Schaltungsvorrichtung für ein Fahrzeug und ein Verfahren zum Betreiben einer Schaltungsvorrichtung zu schaffen.

Diese Aufgabe wird durch eine Schaltungsvorrichtung für ein Fahrzeug und ein Verfahren zum Betreiben einer Schaltungsvorrichtung gemäß den Hauptansprüchen gelöst.

Die mit dem vorgestellten Ansatz erreichbaren Vorteile bestehen darin, das eine Diagnosemethode zur Erkennung unerwünschter Strompfade beispielsweise in Sensoriken realisierbar ist.

Eine Schaltungsvorrichtung für ein Fahrzeug weist die folgenden Merkmale auf:
eine Leiterplatte mit einer Betriebsschaltung zum Betreiben einer Einheit und mit einer ersten Leiterbahn zum Verbinden der Betriebsschaltung mit der Einheit und mit einer zweiten Leiterbahn zum Verbinden der Betriebsschaltung mit der Einheit;
einer Erkennungselektrode zum Erkennen eines zumindest eine der Leiterbahnen betreffenden; und
einer Erkennungseinrichtung, die ausgebildet ist, um unter Verwendung eines an der Erkennungselektrode anliegenden Signals ein den Leckstrom repräsentierendes Erkennungssignal bereitzustellen.

Bei dem Fahrzeug kann es sich beispielsweise um ein Nutzfahrzeug, beispielsweise um einen Lastkraftwagen oder um ein Schienenfahrzeug handeln. Die Schaltungsvorrichtung kann Teil eines Systems des Fahrzeugs sein, beispielsweise Teil eines Bremssystems, eines Lenksystems oder eines Assistenzsystems. Die zu betreibende Einheit kann beispielsweise ein Sensor, ein Aktor oder eine Logikschaltung sein. Die Betriebsschaltung kann ausgebildet sein, um über zumindest eine der Leiterbahnen ein Steuersignal oder ein Betriebssignal an die Einheit bereitzustellen und zusätzlich oder alternativ ein Datensignal von der Einheit zu empfangen. Unter dem Betreiben der Einheit kann somit sowohl die Bereitstellung erforderlicher Signals an die Einheit als auch das Empfangen und gegebenenfalls Auswerten von der Einheit bereitgestellter Signale verstanden werden. Die Betriebsschaltung kann als integrierte Schaltung oder in Form einer Mehrzahl zu einem Schaltkreis verschalteter Bauelemente auf der Leiterplatte angeordnet sein. Die Leiterbahnen können auf einer Oberseite oder im Inneren der Leiterplatte geführt sein. Die Leiterbahnen können eine direkte Verbindung zwischen der Betriebsschaltung und der Einheit darstellen oder zu einem Stecker führen, über den die Einheit kontaktiert werden kann. Zumindest eine der Leiterbahnen kann somit auch einen Abschnitt umfassen, der Teil eines Steckers ist, beispielsweise eine Kontaktfläche des Steckers, ein Kontakt des Steckers oder ein elektrischer Leiter des Steckers, wie beispielsweise ein Kontaktstift oder eine Kontaktbuchse. Die Erkennungselektrode kann an der Leiterplatte ausgeformt sein, beispielsweise in Form einer Leiterbahn oder einer Kontaktfläche oder an der Leiterbahn angeordet sein. Die Erkennungselektrode kann elektrisch von den Leiterbahnen isoliert sein. Die Erkennungselektrode kann zwischen den Leiterbahnen oder zwischen mit den Leiterbahnen verbundenen weiteren Leitungen oder Kontakten angeordnet sein. Unter einem Leckstrom kann ein unerwünschter Stromfluss zu oder von einer der beiden Leiterbahnen verstanden werden. Beispielsweise kann es sich um einen zwischen der ersten Leiterbahn und der zweiten Leiterbahn und/oder zwischen einer der Leiterbahnen und einer weiteren elektrischen Leitung oder elektrischen Potentialfläche der Leiterplatte verstanden werden. Die Erkennungseinrichtung kann ausgebildet sein um einen Wert und/oder eine Charakteristik des an der Erkennungselektrode anliegenden Signals auszuwerten, um das Erkennungssignal bereitzustellen. Beispielsweise kann die Erkennungseinrichtung kann ausgebildet sein, um einen Spannungswert, einen Stromwert und/oder einen zeitlichen Verlauf des an der Erkennungselektrode anliegenden Signals auszuwerten, um das Erkennungssignal bereitzustellen. Die Schaltungsvorrichtung kann die Einheit umfassen.

Die Einheit kann als ein Sensor ausgeführt sein. Entsprechend kann die Betriebsschaltung ausgebildet sein, um die als Sensor ausgeführte Einheit zu betreiben. Der Sensor kann beispielsweise auf einem induktiven, einem kapazitiven oder einem magnetischen Messprinzip beruhen. Somit kann der beschriebene Ansatz vorteilhaft im Zusammenhang mit einer Sensorik eingesetzt werden. Dabei kann es sich insbesondere um sicherheitsrelevante Sensorik handeln. Sensoriken deren Signale durch parasitäre Ströme beeinflusst werden sind weit verbreitet. Der beschriebene Ansatz kann zusätzlich oder alternativ mit passiven, isolierenden Ansätzen eintesetzt werden. Vorteilhafterweise sind bei dem hier vorgestellten Ansatz keine aufwändigen Geometrien erforderlich, um Kriechstrecken zu erhöhen. Auch kann auf gedichtete Stecker oder überlackierte Anschlusspunkte, beispielsweise auf Leiterplatten, verzichtet werden. Somit ist kein hoher Aufwand für Isolierung oder ähnliches erforderlich. Vorteilhafterweise ist die Wirksamkeit, insbesondere die Langzeitwirksamkeit leicht quantifizierbar. Dabei kann auf lange Lebensdauertests und aufwändige Testverfahren verzichtet werden. Stattdessen genügt beispielsweise eine regelmäßige Auswertung des Erkennungssignals. Der beschriebenen Ansatz kann vorteilhafterweise im Zusammenhang mit einem im Bereich der funktionalen Sicherheit einziehenden neuen Stand der Normen verwendet werden, welcher verstärkt auf "in Ihrer Wirkung" quantifizierbare Lösungen zum Nachweis der Absicherung sicherheitskritischer Elektroniken setzt.

Die Betriebsschaltung kann ausgebildet sein, um über zumindest eine der Leiterbahnen ein von der Einheit bereitgestelltes Datensignal einzulesen. Vorteilhafterweise kann ein eine Integrität des Datensignals beeinflussender Leckstrom unter Verwendung der Erkennungselektrode sicher erkannt werden.

Beispielsweise kann die Betriebsschaltung ausgebildet sein, um über zumindest eine der Leiterbahnen ein von der Einheit bereitgestelltes Fehlersignal einzulesen. Ein solches Fehlersignal kann ein sogenanntes "Plausible but Wrong"-Signal sein, das anzeigen kann, dass von der Einheit bereitgestellte Daten zwar plausibel jedoch falsch sind. Das Erkennen eine ein solches Fehlersignal beeinträchtigenden Leckstroms ist wichtig, um die Schaltungsvorrichtung sicher betreiben zu können.

Die Betriebsschaltung und die Einheit können einen hochfrequenten Schwingkreis ausformen. Beispielsweise kann die Betriebsschaltung als eine Oszillatorschaltung ausgebildet sein, um eine als Spule ausgeführte Einheit zu betreiben. Somit können die Betriebsschaltung und die Spule einen Schwingkreis ausformen. Eine Schwingfrequenz des Schwingkreises kann dabei an eine bereitzustellende Funktionalität der Spule angepasst sein. Eine entsprechende Spule kann beispielsweise als Sensor zum Erkennen eines ein Magnetfeld der Spule beeinflussenden Ereignisses verwendet werden.

Die Schaltungsvorrichtung kann einen Stecker zum Verbinden der Einheit mit der Leiterplatte umfassen. Der Stecker kann einen ersten Kontakt zum Kontaktieren eines ersten Anschluss der Einheit, einen zweiten Kontakt zum Kontaktieren eines zweiten Anschluss der Einheit und einen zwischen dem ersten Kontakt und dem zweiten Kontakt angeordneten dritten Kontakt aufweisen. Der erste Kontakt kann mit der ersten Leiterbahn verbunden sein, der zweite Kontakt kann mit der zweiten Leiterbahn verbunden sein und der dritte Kontakt kann mit der Erkennungselektrode verbunden oder als die Erkennungselektrode ausgeführt sein. Ein Stecker eignet sich zum elektrischen Kontaktieren einer extern zu der Leiterplatte angeordneten oder auf der Leiterplatte montierten Einheit. Indem die Erkennungselektrode im Bereich des Steckers angeordnet ist, kann ein für Leckströme anfälliges Bauteil überwacht werden.

Die Erkennungseinrichtung kann ausgebildet sein, um unter Verwendung des Erkennungssignals ein Korrektursignal zum Korrigieren eines über die erste Leiterbahn und/oder die zweite Leiterbahn übertragenen Signals bereitzustellen. Auf diese Weise kann eine Auswirkung eines erkannten Leckstroms auf ein übertragenes Signal korrigiert oder kompensiert werden. Auf diese Weise kann die Schaltungsvorrichtung trotz Leckstroms weiter betrieben werden.

Die Erkennungseinrichtung kann ausgebildet sein, um unter Verwendung des Erkennungssignals ein ein Abschaltsignal zum Abschalten der Einheit bereitzustellen. Auf diese Weise kann die Einheit beispielsweise außer Betrieb genommen werden, wenn der Leckstrom eine kritische Größe erreicht.

Die Erkennungseinrichtung kann ausgebildet sein, um unter Verwendung des Erkennungssignals ein Überführsignal zum Überführen eines die Schaltungsvorrichtung umfassenden Systems in einen sicheren Zustand bereitzustellen. Auf diese Weise kann verhindert werden, dass der Leckstrom zu einem unkontrollierten Zustand des Systems führt.

Die Erkennungseinrichtung kann ausgebildet sein, um unter Verwendung des Erkennungssignals ein oder ein Warnsignal bereitzustellen. Das Warnsignal kann von einer Überwachungseinrichtung verwendet werden oder zum Ansteuern einer Anzeigeeinrichtung, beispielsweise zum Warnen eines Fahrers des Fahrzeugs, verwendet werden.

Die Erkennungseinrichtung kann ausgebildet sein, um einen zeitlichen Verlauf des an der Erkennungselektrode anliegenden Signals zu bestimmen. Ferner kann die Erkennungseinrichtung kann ausgebildet sein, um das Erkennungssignal unter Verwendung des zeitlichen Verlaufs bereitzustellen. Auf diese Weise kann das Erkennungssignal beispielsweise bereitgestellt werden, wenn der Leckstrom innerhalb eines kurzen Zeitintervalls stark zunimmt, sodass mit einem bevorstehenden Ausfall der Schaltungsvorrichtung zu rechnen ist.

Die Erkennungseinrichtung kann ausgebildet sein, um unter Verwendung des an der Erkennungselektrode anliegenden Signals einen elektrischen Widerstandswert zwischen der ersten Leiterbahn und der zweiten Leiterbahn zu bestimmen. Ferner kann die Erkennungseinrichtung kann ausgebildet sein, um das Erkennungssignal unter Verwendung des Widerstandswerts bestimmen. Der Widerstandswert kann als ein sicherer Indikator für den Leckstrom angesehen werden.

Gemäß einer Ausführungsform kann die Schaltungsvorrichtung einen beweglichen Stößel aufweisen. Die Betriebsschaltung kann ausgebildet sein, um unter Verwendung eines über die erste Leiterbahn und die zweite Leiterbahn übermittelten Betriebssignalsein eine Position des beweglichen Stößels repräsentierendes Positionssignal bereitzustellen. Unter Verwendung der Erkennungselektrode kann ein Leckstrom erkannt werden, der zu einer Verfälschung des Betriebssignals und somit zu einer Verfälschung des Positionssignals führen würde. Bei dem Betriebssignal kann es sich um ein von einer Oszillatorschaltung bereitgestelltes Wechselsignal, beispielsweise um eine Wechselspannung handeln.

Ein Verfahren zum Betreiben einer genannten Schaltungsvorrichtung umfasst die folgenden Schritte:
Übertragen eines Betriebssignals über die erste Leiterbahn und die zweite Leiterbahn; und

Auswerten des an der Erkennungselektrode anliegenden Signals, um den Leckstrom zu erkennen.

Dieses Verfahren kann beispielsweise in Software oder Hardware oder in einer Mischform aus Software und Hardware beispielsweise in einem Steuergerät implementiert sein.

Ausführungsbeispiele des hier vorgestellten Ansatzes werden in der nachfolgenden Beschreibung mit Bezug zu den Figuren näher erläutert. Es zeigen:
Fig. 1 eine schematische Darstellung eines Fahrzeugs mit einer Schaltungsvorrichtung gemäß einem Ausführungsbeispiel;
Fig. 2 eine schematische Darstellung eines Abschnitts einer Leiterplatte einer Schaltungsvorrichtung gemäß einem Ausführungsbeispiel;
Fig. 3 eine Schaltungsvorrichtung gemäß einem Ausführungsbeispiel;
Fig. 4 eine Schar gemäß einem Ausführungsbeispiel; und
Fig. 5 ein Ablaufdiagramm eines Verfahrens zum Betreiben einer Schaltungsvorrichtung gemäß einem Ausführungsbeispiel.

In der nachfolgenden Beschreibung günstiger Ausführungsbeispiele des vorliegenden Ansatzes werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

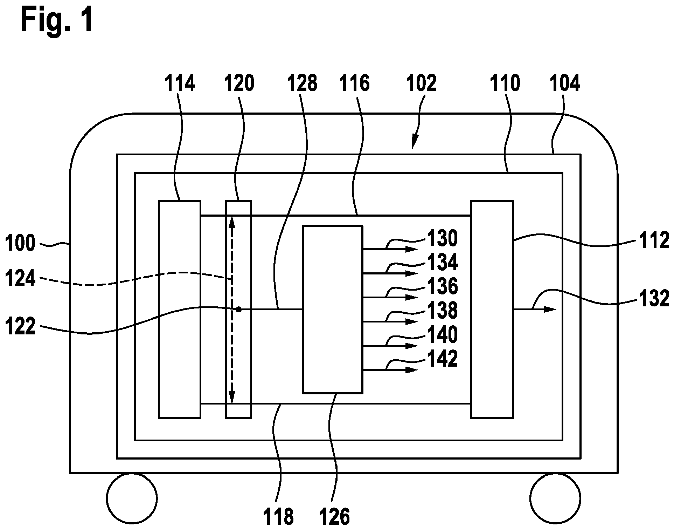

**Fig. 1** zeigt eine schematische Darstellung eines Fahrzeugs 100 mit einer Schaltungsvorrichtung 102 gemäß einem Ausführungsbeispiel. Beispielhaft ist die Schaltungsvorrichtung 102 teil eines Systems 104 des Fahrzeugs 100, beispielsweise eines Bremssystems.

Die Schaltungsvorrichtung 102 umfasst eine Leiterplatte 110, auf der eine Betriebsschaltung 112 zum Betreiben einer Einheit 114 umfasst. Die Einheit 114 kann Teil der Schaltungsvorrichtung 102 oder Teil des Systems 104 sein. Die Einheit 114 kann extern zu der Leiterplatte 110 angeordnet sein oder auf der Leiterplatte montiert sein.

Ein erster Anschluss der Betriebsschaltung 112 ist über eine erste Leiterbahn 116 mit einem ersten Anschluss der Einheit 114 verbunden. Etnsprechend ist ein zweiter Anschluss der Betriebsschaltung 112 über eine zweite Leiterbahn 118 mit einem zweiten Anschluss der Einheit 114 verbunden.

Gemäß einem Ausführungsbeispiel verbinden die Leiterbahnen 116, 118 die Betriebsschaltung 112 direkt mit der Einheit 114. Gemäß einem alternativen Ausführungsbeispiel weist die Leiterplatte 110 einen Stecker 120 auf. In diesem Fall verbindet die erste Leiterbahn 116 den ersten Anschluss der Betriebsschaltung 112 mit einem ersten Kontakt des Steckers 120 und die zweite Leiterbahn 118 den zweiten Anschluss der Betriebsschaltung 112 mit einem zweiten Kontakt des Steckers 120. Der erste Anschluss der Einheit 114 ist in diesem Fall über eine erste Leitung mit dem ersten Kontakt des Steckers 120 und der zweite Anschluss der Einheit 114 über eine zweite Leitung mit dem zweiten Kontakt des Steckers 120 verbunden, beispielsweise unter Verwendung eines mit dem Stecker 120 koppelbaren Gegenstecker. Die Kontakte des Steckers 120 sind beispielsweise als Steckerstifte oder Steckerbuchsen ausgeführt.

Die Schaltungsvorrichtung 102 weist eine Erkennungselektrode 122 zum Erkennen eines Leckstroms 124 auf, der zumindest eine der Leiterbahnen 116, 118 betrifft. Ein solcher Leckstrom geht beispielsweise von einer der Leiterbahnen 116, 118 aus und/oder mündet in eine der Leiterbahnen 116, 118. Somit kann es sich um einen unerwünschten Stromfluss zwischen der ersten Leiterbahn 116 und der zweiten Leiterbahn 118 oder einen unerwünschten Stromfluss zwischen einer der Leiterbahnen 116, 118 und beispielsweise einer weiteren Leiterbahn oder weiteren Potentialfläche handeln. Die Erkennungselektrode 122 ist gemäß unterschiedlicher Ausführugnsbeispiele als Leiterbahn der Leiterplatte 110, als Kontaktfläche der Leiterplatte 110 oder als Teil des Steckers 120, beispielsweise als ein dritter Kontakt des Steckers 120, realisiert. Die Erkennungselektrode 122 ist an einer geeignten Position zwischen oder zumindest benachbart zu den Leiterbahnen 116, 118 oder zumindest einer der Leiterbahnen 116, 118 angeordnet, um den Leckstrom 124 erkennen zu können.

Die Schaltungsvorrichtung 102 weist eine Erkennungseinrichtung 126 auf. Die Erkennungseinrichtung 126 ist gemäß diesem Ausführungsbeispiel auf der Leiterplatte 110 angeordnet. Gemäß einem alternativen Ausführungsbeispiel ist die eine Erkennungseinrichtung 126 extern zu der Leiterplatte 110 angeordnet. Die Erkennungseinrichtung 126 ist gemäß diesem Ausführungsbeispiel über eine dritte Leiterbahn 128 der Leiterplatte 110 mit der Erkennungselektrode 122 verbunden. Alternativ formt die Leiterbahn 128 die Erkennungselektrode 122 aus. Die Erkennungseinrichtung 126 ist ausgebildet ist, um unter Verwendung eines an der Erkennungselektrode 122 anliegenden Signals ein den Leckstrom 124 repräsentierendes Erkennungssignal 130 bereitzustellen. Dazu ist die Erkennungseinrichtung 126 beispielsweise ausgebildet, um einen über die dritte Leiterbahn 128 fließenden Stromwert eines elektrischen Stroms oder einen an der Erkennungselektrode 122 anliegenden Spannungswert einer elektrischen Spannung zu messen und zur Bestimmung einer Größe des Leckstroms 124 zu verwenden. Gemäß einem Ausführungsbeispiel ist die Erkennungseinrichtung 126 ausgebildet, um eine erste Potentialdifferenz zwischen der Erkennungselektrode 122 und der ersten Leiterbahn 116 und eine zweite Potentialdifferenz zwischen der Erkennungselektrode 122 und der zweiten Leiterbahn 118 zu messen und zur Bestimmung einer Größe des Leckstroms 124 zu verwenden. Gemäß einem Ausführungsbeispiel ist die Erkennungseinrichtung 126 ausgebildet, um einen Widerstandswert eines elektrischen Widerstands zwischen der ersten Leiterbahn und der zweiten Leiterbahn zu bestimmen und das Erkennungssignal 130 unter Verwendung des Widerstandswerts bestimmen. Zum Bestimmen des Erkennungssignals 130 ist die Erkennungseinrichtung 126 gemäß einem Ausführungsbeispiel ausgebildet, um zumindest einen Referenzwert oder Schwellenwert, eine Nachschlagetabelle und/oder einen Zuordnungsvorschrift zu verwenden.

Die Einheit 114 ist beispielsweise als ein Sensor oder ein Aktuator oder als eine elektrische Schaltung ausgeführt. Die Betriebsschaltung 112 ist ausgebildet, um über die Leiterbahnen 116, 118 zumindest ein Signal, beipsielsweise ein Betriebssignal, bereitzustellen, das einen Betrieb der Einheit 114 ermöglicht und/oder zumindest ein Signal zu verarbeiten, das von der Einheit 114 bereitgestellt wird. Dabei kann es sich jeweils um ein analoges oder digitales Signal handeln. Über zumindest eine der Leiterbahnen 116, 118 kann ein Betriebsstrom oder eine Betriebsspannung, ein Datensignal, ein Fehlersignal oder ein anderes zum Betrieb der Einheit 114 erforderliches oder während des Betriebs der Einheit 114 von der Einheit 114 bereitgestelltes Signals übertragen werden.

Gemäß einem Ausführungsbeispiel ist die Einheit 114 als ein Sensor ausgeführt, beisielsweise als ein induktiver Sensor, ein kapazitiver Sensor oder ein ein anderes Wirkprinzip aufweisender Sensor. Entsprechend ist die Betriebsschaltung 112 ausgebildet, um ein zum Betreiben des Sensors erforderliches Signal bereitzustellen und/oder ein von dem Sensor bereitgestelltes oder modifiziertes Signal zu empfangen und beispielsweise auszuwerten, um ein Messergebnis zu erhalten.

Gemäß einem Ausführungsbeispiel ist die Einheit 114 als eine Spule ausgeführt und die Betriebsschaltung 112 stellt eine Oszillatorschaltung zum Bereitstellen eines zur Anregung der Spule geeigneten Betriebssignals, beispielsweise ein Wechselstromsignal oder Wechselspannungsignal, an die Leiterbahnen 116, 118 dar. In diesem Fall bilden die Betriebsschaltung 112 und die Einheit 114 einen Schwingkreis. Die Betriebsschaltung 112 ist beispielsweise ausgebildet, um über eine Charakteristik des Betriebssignals eine Beeinflussung eines von der Einheit 114 erzeugten Magnetfelds zu erkennen und auszuwerten. Das Magnetfeld wird beispielsweise durch eine Position oder Bewegung eines Stößels beeinflusst. Gemäß einem Ausführungsbeispiel ist die Betriebsschaltung ausgebildet, um unter Verwendung des an den Leiterbahnen 116, 118 anliegenden Betriebssignals eine Position eines solchen beweglichen Stößels zu bestimmen und ein die Position repräsentierendes Positionssignal 132 bereitzustellen.

Wenn der Leckstrom 124 auftritt, führt dies gemäß einem Ausführungsbeispiel zu einer Veränderung eines über zumindest eine der Leiterbahnen 116, 118 übertragenen Signals.

Gemäß einem Ausführungsbeispiel ist die Erkennungseinrichtung 126 ausgebildet, um unter Verwendung des Erkennungssignals 130 ein Korrektursignal 134 bereitzustellen, das beispielsweise von der Betriebsschaltung 112 verwendet wird, um ein über zumindest eine der Leiterbahnen 116, 118 übertragenes Signal zu korrigieren. Das Korrektursignal 134 kann zusätzlich oder alternativ zu dem Erkennungssignal 130 von der Erkennungseinrichtung 126 ausgegeben werden. Zusätzlich oder alternativ ist die Erkennungseinrichtung 126 ausgebildet, um unter Verwendung des Erkennungssignals 130 ein Abschaltsignal 136 zum Abschalten der Einheit 114, beipsielsweise an eine Schnittstelle zu der Einheit 114 oder der Betriebsschaltung 112 bereitzustellen. Zusätzlich oder alternativ ist die Erkennungseinrichtung 126 ausgebildet, um unter Verwendung des Erkennungssignals 130 ein Überführsignal 138 bereitzustellen, das geeignet ist, um die Betriebsschaltung 112 oder das System 114 in einen sicheren Zustand zu überführen. Zusätzlich oder alternativ ist die Erkennungseinrichtung 126 ausgebildet, um unter Verwendung des Erkennungssignals 130 ein Warnsignal 140 bereitzustellen. Das Warnsignal 140 wird beispielsweise verwendet um ein für einen Fahrer des Fahrzeugs 100 sichtbares Warnlicht zu aktivieren.

Gemäß einem Ausführungsbeispiel ist die Erkennungseinrichtung 126 ausgebildet, um einen zeitlichen Verlauf des an der Erkennungselektrode 122 anliegenden Signals zu bestimmen und das Erkennungssignal 130 unter Verwendung des zeitlichen Verlaufs bereitzustellen. Beispielsweise ist die Erkennungseinrichtung 126 ausgebildet um das Erkennungssignal 130 bereitzustellen, wenn der zeitliche Verlauf des an der Erkennungselektrode 122 anliegenden Signals eine vorbestimmte Verlaufscharakteristik aufweist. Zusätzlich oder alternativ ist die Erkennungseinrichtung 126 ausgebildet, um den zeitlichen Verlauf des an der Erkennungselektrode 122 anliegenden Signals als ein Verlaufsignal 142 bereitzustellen. Dies ermöglicht beispielsweise eine Auswertung eines zeitlichen Verlaufs des Leckstroms 124

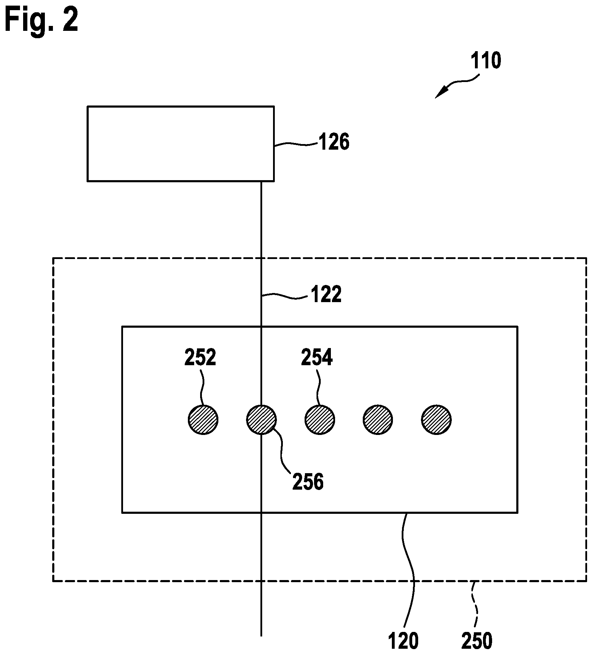

**Fig. 2** zeigt eine schematische Darstellung eines Abschnitts einer Leiterplatte 110 einer Schaltungsvorrichtung 102 gemäß einem Ausführungsbeispiel. Die Leiterplatte 110 kann ein Ausführungsbeispiel der anhand von Fig. 1 beschriebenen Leiterplatte sein.

Die Leiterplatte 110 weist eine lackierte Oberfläche auf. Ein rechteckiger Abschnitt der Oberfläche der Leiterplatte 110 in dem ein Stecker 120 angeordnet ist, ist von der Lackierung ausgenommen. In Fig. 2 ist eine Grenze 250 des durch Lack geschützten Bereichs kennzeichnet, wobei im Inneren des durch die Grenze 250 umschlossenen Abschnitts kein Lack angeordnet ist.

Der Stecker 120 weist zumindest einen ersten Kontakt 252, einen zweiten Kontakt 254 und einen dritten Kontakt 256 auf. Dabei ist der dritte Kontakt 256 zwischen dem ersten Kontakt 252 und dem zweiten Kontakt 254 angeordnet. Die Kontakte 252, 254, 256 sind in einer Reihe angeordnet. Beispielhaft weist der Stecker 120 noch zwei weitere Kontakte auf. Beispielhaft sind die Kontakte 252, 254, 256 des Steckes 120 als Pins ausgeführt.

Gemäß diesem Ausführungsbeispiel ist die Erkennungselektrode 122 als eine Leiterbahn ausgeführt, die elektrisch leitfähig mit dem dritten Kontakt 256 verbunden ist. Somit ist die Erkennungseinrichtung 126 über die Erkennungselektrode 122 mit dem dritten Kontakt 256 verbunden. Beispielhaft ist die Erkennungselektrode 122 als eine Leiterbahn ausgeführt, die geradlinig durch den von der Grenze 250 umgegebenen unlackierten Abschnitt hindurch verläuft.

Die Erkennungselektrode 122 wird auch als Überwachungselektrode bezeichnet, die von der Erkennungseinrichtung 126 überwacht wird. Die Erkennungseinrichtung 126 wird auch als Logik oder Überwachungslogik bezeichnet ist und beispielsweise als Mikrocontroller oder als ein in Hardware oder Software realisierter Algorythmus ausgeführt. Eine Sensitivität der Erkennungseinrichtung 126 ist gemäß einem Ausführungsbeispiel einstellbar. Beispielsweise ist die Funktionalität der Erkennungseinrichtung 126 in einem Steuergerät realisiert.

Unter Verwendung der Erkennungselektrode 122 und der Erkennungseinrichtung 126 kann im Unterschied zu passiven Schutzmechanismen die Bildung von unerwünschten Strompfaden aktiv erkannt werden. Hierzu wird die Erkennungselektrode 122 angebracht und ihr elektrischer Zustand von einer Logik, hier der Erkennungseinrichtung 126 überwacht. Dies geschieht in räumlicher Nähe von Punkten für die gilt, dass die Bildung eines Strompfads, also die Absenkung des Wiederstandes zwischen den Punkten, unvorteilhaft und/oder unerwünscht ist. Beispielsweise handelt es sich bei den Punkten um die Kontakte 252, 254.

Gemäß einem Ausüfhrungsbeispiel werden die Kontakte 252, 254 verwendet, um Anschlüsse einer Einheit zu kontaktieren, wie sie anhand von Fig. 1 beschrieben ist. Im Folgenden wird dabei angenommen, dass es sich bei der Einheit um einen Sensor handelt.

Die Anordnung aus Erkennungselektrode 122 und Erkennungseinrichtung 126 ist dabei dergestalt so ausgeführt, dass der Mechanismus nachweislich in der Lage ist die Entstehung von parasitären, also unerwünschten und für den Betrieb nachteiligen, Strompfaden zu erkennen.

Der Nutzen besteht in einer Erkennung einer entstehenden Beeinflussung bevor es zu einer sicherheitsrelevanten Beeinträchtigung der mit dem Betrieb des Sensors in verbindungstehenden Strömen kommt, beziehungsweise innerhalb einem zeitlichen Rahmen der die Einhaltung der Prozesssicherheitszeit ermöglicht. Daraus ergibt sich die folgende Möglichkeit einer Systemreaktion hin zu einem sicheren Zustand.

Vorteihafterweise wird der Einsatz von Bauteilen, wie mit reduzierter Komplexität ermöglicht. Daraus ergibt sich ein Kostenvorteil und eine Verwendbarkeit einer Vielzahl von Bauteilen, beispielsweise des Steckers 120 in Form eines ungedichteten Steckers. Es besteht die Möglichkeit zum Wegfall schwieriger und/oder teurer Fertigungsprozessschritte, wie beispielsweise Lackieren nach dem Löten oder Vergießen. Daraus folgt eine Begünstigung des Einsatzes von bevorzugten Fertigungsverfahren, beispielsweise SMD-Bauweise, Alusubstratleiterplatten, Leiterplatten ohne Möglichkeit zur Durchkontaktierung, unter sicherheitsrelevanten Gesichtspunkten. Es besteht die Möglichkeit zur testbaren Ausführung der Detektionsmethode, woraus ein Nachweis des Sicherheitsmechanismus über die Einsatzzeit folt, wodurch sich die Sicherheit erhöht. Zudem ist ein quantifizierbarer Nachweis eines Schutzes vor unerwünschten Strömen möglich. Dabei kann der Diagnosedekungsgrad im Sinne der Sicherheitsnorm oder ähnlichem liegen.

Anhand des in Fig. 2 gezeigten Ausführungsbeispiel wird der Schutz vor Bildung (unerkannter) Strompfade zwischen dem ersten Kontakt 252 und dem Kontakt 254 sowie den weiteren Kontakten, die auf der dem ersten Kontakt 252 gegenüberliegenden Seite der Erkennungselektrode 122 angeordnet sind.

Gemäß einem Ausführungsbeisipel gilt, dass die Geometrie der Anordnung so ausgeführt ist, dass Sie nachweislich die Erkennungsfunktion ermöglicht. Dabei wird eine Erkennung ermöglicht, bevor ein unerwünschter Effekt, der beispielsweise ein über zumindest einen der Kontakte 252, 254 geführtes Sensorsignal beeinflusst, eintritt, beziehungsweise in einem zeitlichen Rahmen der die Einhaltung der Prozesssicherheitszeit ermöglicht.

Alternativ zu dem in Fig. 2 gezeigten Ausführungsbeispiel kann der Stecker 120 anstatt auf der als Platine ausgeführten Leiterplatte 110 entfernt zu der Leiterplatte 110 angeordnet sein. Der dritte Kontakt 256 in Form eines Steckerpins kann im Inneren des Steckers 120 durch die Erkennungselektrode 122 kontaktiert sein. Alternativ kann der Stecker 120 ohne Kontaktierung im Inneren des Steckers 120 ausgeführt sein und stattdessen kann die Erkennungselektrode 122 außen kontaktiert sein. Wie in Fig. 2 gezeigt, kann ein dritter Kontakt 256 zwischen zwei oder mehre Kontakte 252, 254 beziehungsweise Spannungsbehaftete gestellt werden. Alterantiv können mehrere dritte Kontakte 256 zwischen zwei oder mehrere Kontakte 252, 254 beziehungsweise Spannungsbehaftete gestellt werden. Über die Kontakte 252, 254 kann ein Informationskanal verlaufen. Alternativ kann die Anordnung zur Detektion mehrerer Kanäle verwendet oder ausgeweitet werden.

Bei dem über den Stecker 120 kontaktierbaren Sensor kann es sich um einen im Nutzfahrzeugbereich verwendbaren Sensor handeln. Über die Kontakte 252, 254 können sensorische Signalkanäle geführt werden. Insbesonder kann über zumindest einen der Kontakte 252, 254 ein Signalausgang geführt werden, da der Signalausgang besonders für die Sicherheit relevant ist. Dies ist ein wesentlicher Unterschied zu einer normalen Stromschutzerkennung oder ähnlichem.

Die Erkennungseinrichtung 126 wird gemäß einem Ausführungsbeispiel verwendet um zu Erkennen, dass ein über zumindest einen der Kontakte 252, 254 geführtes Signals verfälscht wird oder würde, bei dem es sich um ein sogneanntes "Plausible but Wrong"-Signal handelt.

Gemäß einem Ausführungsbeispiel wird der Stecker 120 verwendet, um eine Kontaktierung einer oder mehrerer Spulen in einem oder mehreren Schwingkreisen zu ermöglichen. Dabei kann ein solcher Schwingkreis auf eine spezielle Schwingungsfrequenz aufweisen.

Vorteilhafterweise kann unter Verwendung der Erkennungselektrode 122 ein gegebenenfalls erhöhter Automotive Integrety Level erreicht werden. Dadurch kann beispielsweise eine spezifizierte Sicherheitsanforderungsstufe für sicherheitsrelevante Systeme in Kraftfahrzeugen erreicht werden.

Gemäß unterschiedlicher Ausführungsbeispiele wird über zumindest einen der Kontakte 252, 254 ein Gleichstrom, ein Wechselstrom, hochfrequente Ströme größer als Ströme des normalen Stromnetzes mit 50/60/XXHz, ein analoger Signalstrom, ein Betriebstrom und/oder ein Anregungsstrom übertragen.

Gemäß einem Ausführungsbeispiel erfolgt die Erkennung des Leckstroms innerhalb des Steckers 120.

Gemäß einem Ausführungsbeispiel wird eine Sensorik überwacht, der ein Analogspannungsignal zugeführt wird. Zusätzlich oder alternativ erfolgt eine Absicherung eines hochfrequenten Schwingkreises. Die Ableitung zu der Erkennungseinrichtung 126 erfolgt auf der Leiterplatte 110, bei der es sich um eine gedruckte Leiterplatte handeln kann, und nicht in einem Kabel. Die Erkennungselektrode 122 wird nicht eingesetzt, um eine gezielte Wiederstandänderung hervorzurufen sondern, um eine gegebenenfalls unerwünschte Wiederstandänderung zu erkennen.

Gemäß einem Ausführungsbeispiel erfolgt über die Erkennungselektrode 122 keine Erdungserfassung sondern, gegebenenfalls auch, die Erfassung von Widerstandsabsenkungen zwischen den Kontakten 252, 254 , deren Potential nicht der Erde entspricht. Hier, was speziell vorteilhaft in der Sensorik ist, besteht auch die Möglichkeit der Erfassung eines kontinuierlichen Lekstrom- und/oder Widerstandsabsenkungsverlaufes, nicht nur anhand eines einzelnen Schwellenwerts. Dies kann bei bekanntem Einfluss, z.B. einem Delta(signalwert) über Widerstand, der in der Entwiklung vermessen und in einem Steuergerät oder der Erkennungseinrichtung 126 hinterlegt ist, zu einer Korrektur eines durch den Leckstrom verfälschten Signal genutzt werden.

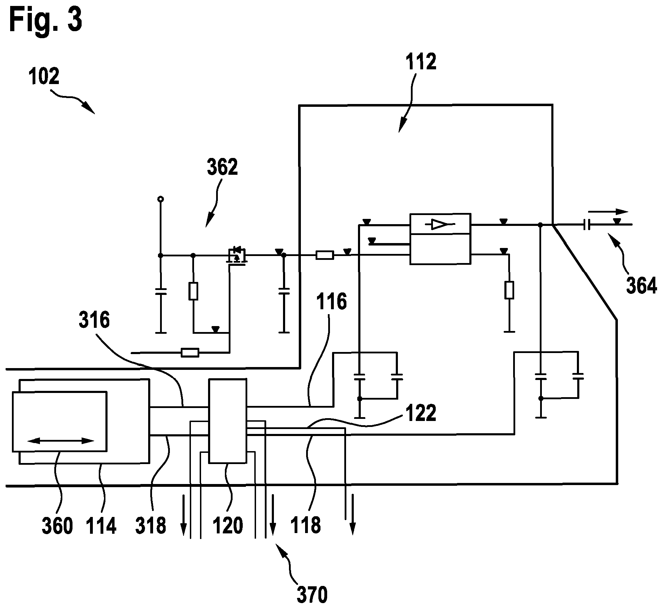

**Fig. 3** zeigt eine Schaltungsvorrichtung 102 gemäß einem Ausführungsbeispiel. Dabei kann es sich um ein Ausüfhrungsbeispiel der anhand von Fig. 1 beschriebenen Schaltungsvorrichtung handeln.

Die eine Schaltungsvorrichtung 102 umfasst eine Betriebsschaltung 112, die über eine erste Leiterbahn 116 und eine zweite Leiterbahn 118, einen Stecker 120 sowie eine erste Leitungen 316 und eine zweite Leitung 318 mit einer Einheit 114 verbunden ist, die hier als eine Spule, hier eine sogenannte "Select-Coil" ausgeführt ist. Die Einheit 114 ist ausgebildet, um ein bewegliches Ziel, hier in Form eines beweglichen Stößels 360 zu sensieren. Die mögliche Bewegung des beweglichen Stößels 360 ist durch einen Doppelpfeil angedeutet.

Die erste Leiterbahn 116 ist über einen ersten Kontakt des Steckers 120 mit der ersten Leitung 316 verbunden. Die zweite Leiterbahn 118 ist über einen zweiten Kontakt des Stecker 120 mit der zweiten Leitung 318 verbunden. Zwischen dem ersten Kontakt und dem zweiten Kontakt ist ein dritter Kontakt angeordnet der als Erkennungselektrode dient oder elktrisch leitfähig mit einer als Erkennungselektrode 122 ausgeführten Leiterbahn verbunden ist. Gemäß einem Ausführungsbeispiel ist die Erkennungselektrode 122 mit einer Erkennungseinrichtung in Form eines Mikrocontrollers verbunden. Der Mikrocontroller ist beispielsweise ausgeführt, um einen abgesenkten Widerstand zu erkennen.

Gemäß einem Ausüfhrungsbeispiel ist über den Stecker 120 ein weiteres Leitungspaar 370 geführt, die eine weitere Spule zum Bewegen des Stößels 360 oder eines weiteren Stößels mit einer Elektronik, beispielsweise in Form einer weiteren Oszillatorschaltung, zum Ansteuern der weiteren Spule verbinden. Auf diese Weise kann unter Verwendung der Erkennungselektrode 122 auch ein das weitere Leitungspaar 370 betreffender Leckstrom erkannt werden.

Die Betriebsschaltung 112 weist eine Spannungsversorgungseinrichtung 362 und einen Datenausgang 364 auf, der beispielsweise als eine Schnittstelle zu dem Microcontroller, der die Funktionalität der Erkennungseinrichtung umfasst oder zu einem weiteren Microcontroller dient. Über den Datenausgang 364 kann beispielsweise ein Positionssignal ausgegeben werden, das eine aktuelle Position des Stößels 360 anzeigt.

Die benötigte Position oder die benötigten Positionen der Erkennungselektrode 122 oder einer Mehrzahl von Erkennungselektrode hängt vom sogenannten Pinning im Stecker 120 ab und ist in Fig. 3 daher nur schematisch gezeigt.

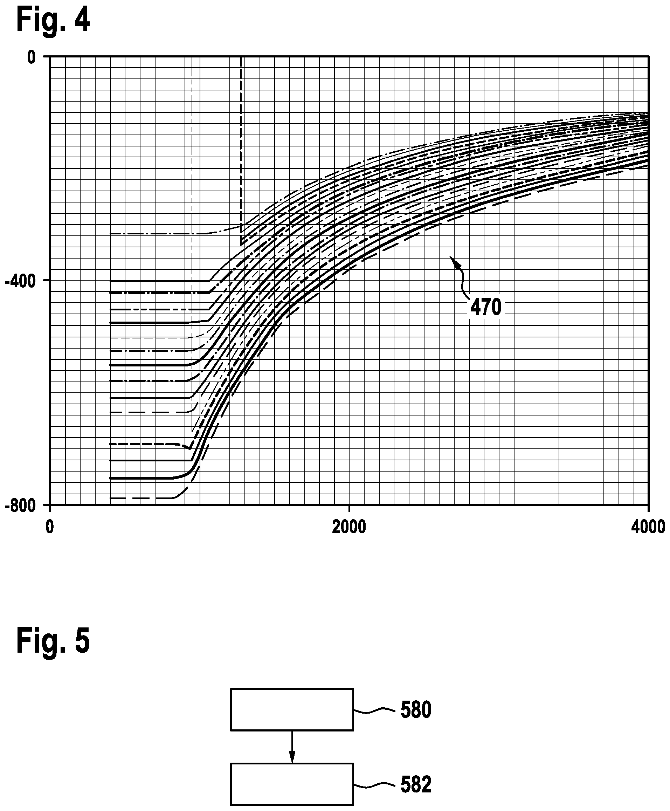

**Fig. 4** zeigt eine Schar 470, die sich gemäß einem Ausführungsbeispiel aus verschiedenen Stößelpositionen, beispielsweise des in Fig. 3 gezeigten Stößels, ergibt. Auf der Abszisse ist der Schmutzwiderstand in Ohm und auf der Ordinate die Fehleranzahl aufgetragen. Beispielhaft sind auf der Abszisse Widerstandswerte zwischen 0 Ohm und 4000 Ohm und auf der Ordinate eine Fehleranzahl zwischen -800 und 0 aufgetragen.

Die oberste Kurve der Schar 470 ist einer Stößelposition von -1mm und die unterste Kurve der Schar 470 ist einer einer Stößelposition von 17mm zugeordnet. Die dazwischenliegenden Kurven sind weiteren sich um jeweils einen Millimeter unterscheidenden Stößelpositionen zugeordnet.

In Fällen in denen eine weitestgehend präzise Charakterisierung des Fehlereinfluss nicht möglich ist, sondern nur eine etwas gröberer Fehlerrahmen durch die Kenntnis des Widerstands ermittelt werden kann, unterstützt die Ermittlung eventuell nicht die komplette Kompensation des Fehlers, kann aber eine Degradationsstrategie auf Systemebene unterstützen, beispielsweise in dem in etwa ein gröberes Regeln als, gegebenenfalls temporäres, Notlaufprogramm durchgeführt wird. Gerade bei Funktionen des hochautomatisierten Fahrens ist die von Interesse oder Vorteil.

Mögliche Systemreaktionen, beispielsweise als Folgeschritt der Auswertelogik, bestehen in einer Kompensation des Signalwerts oder einer festgelegten Reaktion, wie beispielsweie dem Abschalten des Sensors, ein Überführen des Systems in einen sicheren Zustand, eine Fahrer-Warnung, oder beides je nach Widerstandsgröße.

**Fig. 5** zeigt ein Ablaufdiagramm eines Verfahrens zum Betreiben einer Schaltungsvorrichtung, wie sie beispielsweise anhand der vorangegangenen Figuren beschrieben ist, gemäß einem Ausführungsbeispiel. In einem Schritt 580 wird ein Betriebssignall über die erste Leiterbahn und die zweite Leiterbahn übertragen, also beispielsweise auch über den in Fig. 2 gezeigten ersten und zweiten Kontakt des Steckers. In einem Schritt 582 wird das an der Erkennungselektrode anliegende Signal ausgewertet, um den Leckstrom zu erkennen. Die Schritte 580, 582 und insbesondere der Schritt 582 können wiederholt ausgeführt werden, um beispielsweise kontinuierlich das Vorhandensein eines Leckstroms sowie eine Größe des Leckstroms überwachen zu können.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

### BEZUGSZEICHENLISTE

- 100: Fahrzeug
- 102: Schaltungsvorrichtung
- 104: System
- 110: Leiterplatte
- 112: Betriebsschaltung
- 114: Einheit
- 116: erste Leiterbahn
- 118: zweite Leiterbahn
- 120: Stecker
- 122: Erkennungselektrode
- 124: Leckstrom
- 126: Erkennungseinrichtung
- 128: dritte Leiterbahn
- 130: Erkennungssignal
- 132: Positionssignal
- 134: Korrektursignal
- 136: Abschaltsignal
- 138: Überführsignal
- 140: Warnsignal
- 142: Verlaufsignal
- 250: Grenze
- 252: erster Kontakt
- 254: zweiter Kontakt
- 256: dritter Kontakt
- 316: erste Leitung
- 318: zweite Leitung
- 360: Stößel
- 370: Leitungspaar
- 470: Schar
- 580: Schritt des Übertragens
- 582: Schritt des Auswertens

## Patentansprüche

1. Schaltungsvorrichtung (102) für ein Fahrzeug (100), mit folgenden Merkmalen:
einer Leiterplatte (110) mit einer Betriebsschaltung (112) zum Betreiben einer Einheit (114) und mit einer ersten Leiterbahn (116) zum Verbinden der Betriebsschaltung (112) mit der Einheit (114) und mit einer zweiten Leiterbahn (118) zum Verbinden der Betriebsschaltung (112) mit der Einheit (114);
einer Erkennungselektrode (122) zum Erkennen eines zumindest eine der Leiterbahnen (116, 118) betreffenden Leckstroms (124); und
einer Erkennungseinrichtung (112), die ausgebildet ist, um unter Verwendung eines an der Erkennungselektrode (122) anliegenden Signals ein den Leckstrom (124) repräsentierendes Erkennungssignal (130) bereitzustellen,
**dadurch gekennzeichnet, dass**
die Erkennungseinrichtung (112) ausgebildet ist, um unter Verwendung des Erkennungssignals (130) ein Korrektursignal (134) zum Korrigieren eines über die erste Leiterbahn (116) und/oder die zweite Leiterbahn (118) übertragenen und durch den Leckstrom (124) verfälschten Signals bereitzustellen.

2. Schaltungsvorrichtung (102) gemäß Anspruch 1, bei der die Erkennungselektrode (122) zum Erkennen des Leckstroms (124) zwischen der ersten Leiterbahn (116) und der zweiten Leiterbahn (118) und/oder des Leckstroms (124) zwischen einer der Leiterbahnen (116, 118) und einer weiteren elektrischen Leitung oder elektrischen Potentialfläche der Leiterplatte (110) angeordnet ist.

3. Schaltungsvorrichtung (102) gemäß einem der vorangegangenen Ansprüche, bei der die Betriebsschaltung (112) ausgebildet ist, um eine als Sensor ausgeführte Einheit (114) zu betreiben.

4. Schaltungsvorrichtung (102) gemäß einem der vorangegangenen Ansprüche, bei der die Betriebsschaltung (112) ausgebildet ist, um über zumindest eine der Leiterbahnen (116, 118) ein von der Einheit (114) bereitgestelltes Datensignal einzulesen.

5. Schaltungsvorrichtung (102) gemäß einem der vorangegangenen Ansprüche, bei der die Betriebsschaltung (112) ausgebildet ist, um über zumindest eine der Leiterbahnen (116, 118) ein von der Einheit (114) bereitgestelltes Fehlersignal einzulesen.

6. Schaltungsvorrichtung (102) gemäß einem der vorangegangenen Ansprüche, bei der die Betriebsschaltung (112) und die Einheit (114) einen hochfrequenten Schwingkreis ausformen.

7. Schaltungsvorrichtung (102) gemäß einem der vorangegangenen Ansprüche, bei der die Betriebsschaltung (112) als eine Oszillatorschaltung ausgebildet ist, um eine als Spule ausgeführte Einheit (114) zu betreiben.

8. Schaltungsvorrichtung (102) gemäß einem der vorangegangenen Ansprüche, mit einem Stecker (120) zum Verbinden der Einheit (114) mit der Leiterplatte (110), wobei der Stecker (120) einen ersten Kontakt (252) zum Kontaktieren eines ersten Anschluss der Einheit (114), einen zweiten Kontakt (254) zum Kontaktieren eines zweiten Anschluss der Einheit (114) und einen zwischen dem ersten Kontakt (252) und dem zweiten Kontakt (254) angeordneten dritten Kontakt (256) aufweist, wobei der erste Kontakt (252) mit der ersten Leiterbahn (116) verbunden ist, der zweite Kontakt (254) mit der zweiten Leiterbahn (118) verbunden ist und der dritte Kontakt (256) mit der Erkennungselektrode (122) verbunden oder als die Erkennungselektrode (122) ausgeführt ist.

9. Schaltungsvorrichtung (102) gemäß einem der vorangegangenen Ansprüche, bei der die Erkennungseinrichtung (112) ausgebildet ist, um unter Verwendung des Erkennungssignals (130) ein Abschaltsignal (136) zum Abschalten der Einheit (114) und/oder ein Überführsignal (138) zum Überführen eines die Schaltungsvorrichtung (102) umfassenden Systems (104) in einen sicheren Zustand oder ein Warnsignal (140) bereitzustellen.

10. Schaltungsvorrichtung (102) gemäß einem der vorangegangenen Ansprüche, bei der die Erkennungseinrichtung (112) ausgebildet ist, um einen zeitlichen Verlauf des an der Erkennungselektrode (122) anliegenden Signals zu bestimmen und das Erkennungssignal (130) unter Verwendung des zeitlichen Verlaufs bereitzustellen.

11. Schaltungsvorrichtung (102) gemäß einem der vorangegangenen Ansprüche, bei der die Erkennungseinrichtung (112) ausgebildet ist, um unter Verwendung eines an der Erkennungselektrode (122) anliegenden Signals einen elektrischen Widerstandswert zwischen der ersten Leiterbahn (116) und der zweiten Leiterbahn (118) zu bestimmen und das Erkennungssignal (130) unter Verwendung des Widerstandswerts bestimmen.

12. Schaltungsvorrichtung (102) gemäß einem der vorangegangenen Ansprüche, die einen beweglichen Stößel (360) aufweist, und wobei die Betriebsschaltung (112) ausgebildet ist, um unter Verwendung eines über die erste Leiterbahn (116) und die zweite Leiterbahn (118) übermittelten Betriebssignals ein, eine Position des beweglichen Stößels (360) repräsentierendes, Positionssignal (132) bereitzustellen.

13. Verfahren zum Betreiben einer Schaltungsvorrichtung (102) gemäß einem der vorangegangenen Ansprüche, wobei das Verfahren die folgenden Schritte umfasst:
Übertragen (580) eines Betriebssignals über die erste Leiterbahn (116) und die zweite Leiterbahn (118);
Auswerten (582) des an der Erkennungselektrode (122) anliegenden Signals, um den Leckstrom (124) zu erkennen und ein den Leckstrom (124) repräsentierendes Erkennungssignal (130) bereitzustellen;
**gekennzeichnet durch** einen Schritt des
Bereitstellens eines Korrektursignals (134) unter Verwendung des Erkennungssignals (130), um ein über die erste Leiterbahn (116) und/oder die zweite Leiterbahn (118) übertragenes und durch den Leckstrom (124) verfälschtes Signal zu korrigieren.

## Claims

1. Circuit device (102) for a vehicle (100), having the following features:
a printed circuit board (110) having an operating circuit (112) for operating a unit (114), and having a first conductor track (116) for connecting the operating circuit (112) to the unit (114), and a having second conductor track (118) for connecting the operating circuit (112) to the unit (114);
a detection electrode (122) for detecting a leakage current (124) affecting at least one of the conductor tracks (116, 118); and
a detection means (112) designed to use a signal applied to the detection electrode (122) in order to provide a detection signal (130) representing the leakage current (124),
**characterised in that**
the detection means (112) is designed to use the detection signal (130) in order to provide a correction signal (134) for correcting a signal transmitted via the first conductor track (116) and/or the second conductor track (118) and distorted by the leakage current (124).

2. Circuit device (102) according to claim 1, in which the detection electrode (122) is arranged to detect the leakage current (124) between the first conductor track (116) and the second conductor track (118) and/or the leakage current (124) between one of the conductor tracks (116, 118) and a further electrical line or electrical potential surface of the printed circuit board (110).

3. Circuit device (102) according to any of the preceding claims, in which the operating circuit (112) is designed to operate a unit (114) realised as a sensor.

4. Circuit device (102) according to any of the preceding claims, in which the operating circuit (112) is designed to read in, via at least one of the conductor tracks (116, 118), a data signal provided by the unit (114).

5. Circuit device (102) according to any of the preceding claims, in which the operating circuit (112) is designed to read in, via at least one of the conductor tracks (116, 118), an error signal provided by the unit (114).

6. Circuit device (102) according to any of the preceding claims, in which the operating circuit (112) and the unit (114) form a high-frequency resonant circuit.

7. Circuit device (102) according to any of the preceding claims, in which the operating circuit (112) is realised as an oscillator circuit in order to operate a unit (114) realised as a coil.

8. Circuit device (102) according to any of the preceding claims, having a connector (120) for connecting the unit (114) to the printed circuit board (110), wherein the connector (120 has a first contact (252) for contacting a first terminal of the unit (114), a second contact (254) for contacting a second terminal of the unit (114), and a third contact (256) arranged between the first contact (252) and the second contact (254), wherein the first contact (252) is connected to the first conductor track (116), the second contact (254) is connected to the second conductor track (118), and the third contact (256) is connected to the detection electrode (122) or realised as the detection electrode (122).

9. Circuit device (102) according to any of the preceding claims, in which the detection means (112) is designed to use the detection signal (130) in order to provide a switch-off signal (136) for switching off the unit (114) and/or a change-over signal (138) for changing over a system (104) comprising the circuit device (102) to a safe state, or a warning signal (140).

10. Circuit device (102) according to any of the preceding claims, in which the detection means (112) is designed to determine a time profile of the signal applied to the detection electrode (122), and to use the time profile to provide the detection signal (130).

11. Circuit device (102) according to any of the preceding claims, in which the detection means (112) is designed to use a signal applied to the detection electrode (122) in order to determine an electrical resistance value between the first conductor track (116) and the second conductor track (118), and to use the resistance value in order to determine the detection signal (130).

12. Circuit device (102) according to any of the preceding claims, having a movable plunger (360), and wherein the operating circuit (112) is designed to use an operating signal, transmitted via the first conductor track (116) and the second conductor track (118), in order to provide a position signal (132) representing a position of the movable plunger (360).

13. Method for operating a circuit device (102) according to any one of the preceding claims, wherein the method comprises the following steps:
transmitting (580) an operating signal via the first conductor track (116) and the second conductor track (118);
evaluating (582) the signal applied to the detection electrode (122), in order to detect the leakage current (124) and to provide a detection signal (130) representing the leakage current (124);
**characterised by** a step of
using the detection signal (130) in order to provide a correction signal (134) for correcting a signal transmitted via the first conductor track (116) and/or the second conductor track (118) and distorted by the leakage current (124).

## Revendications

1. Ensemble (102) circuit pour un véhicule (100), ayant les caractéristiques suivantes :
une plaquette (110) à circuit imprimé ayant un circuit (112) de fonctionnement pour faire fonctionner une unité (114) et ayant une première piste (116) conductrice pour la connexion du circuit (112) de fonctionnement à l'unité (114) et ayant une deuxième piste (118) conductrice pour la connexion du circuit (112) de fonctionnement à l'unité (114) ;
une électrode (122) de détection pour la détection d'un courant (124) de fuite concernant au moins une l'une des pistes (116, 118) conductrices ; et
un dispositif (112) de détection, qui est constitué pour, en utilisant un signal appliqué à l'électrode (122) de détection, disposer d'un signal (130) de détection représentant le courant (124) de fuite,
**caractérisé en ce que**
le dispositif (112) de détection est constitué pour, en utilisant le signal (130) de détection, disposer d'un signal (134) de correction pour la correction d'un signal transmis par la première piste (116) conductrice et/ou la deuxième piste (118) conductrice et faussé par le courant (124) de fuite.

2. Ensemble (102) circuit suivant la revendication 1, dans lequel l'électrode (122) de détection est montée pour la détection du courant (124) de fuite entre la première piste (116) conductrice et la deuxième piste (118) conductrice et/ou du courant (124) de fuite entre l'une des pistes (116, 118) conductrices et une autre ligne électrique ou une surface de potentiel électrique de la plaque (110) à circuit imprimé.

3. Ensemble (102) circuit suivant l'une des revendications précédentes, dans lequel le circuit (112) de fonctionnement est constitué pour faire fonctionner une unité (114) réalisée en capteur.

4. Ensemble (102) circuit suivant l'une des revendications précédentes, dans lequel le circuit (112) de fonctionnement est constitué pour lire, par au moins l'une des pistes (116, 118) conductrices, un signal de données mis à disposition par l'unité (114) .

5. Ensemble (102) circuit suivant l'une des revendications précédentes, dans lequel le circuit (112) de fonctionnement est constitué pour lire, par au moins l'une des pistes (116, 118) conductrices, un signal de défaut mis à disposition par l'unité (114).

6. Ensemble (102) circuit suivant l'une des revendications précédentes, dans lequel le circuit (112) de fonctionnement et l'unité (114) forment un circuit oscillant de haute fréquence.

7. Ensemble (102) circuit suivant l'une des revendications précédentes, dans lequel le circuit (112) de fonctionnement est constitué sous la forme d'un circuit d'oscillateur, afin de faire fonctionner une unité (114) réalisée en bobine.

8. Ensemble (102) circuit suivant l'une des revendications précédentes, comprenant un connecteur (120) pour relier l'unité (114) à la plaquette (110) de circuit imprimé, dans lequel le connecteur (120) a un premier contact (252) pour la mise en contact d'une première borne de l'unité (114), un deuxième contact (254) pour la mise en contact d'une deuxième borne de l'unité (114) et un troisième contact (256) disposé entre le premier contact (252) et le deuxième contact (254), dans lequel le premier contact (252) est relié à la première piste (116) conductrice, le deuxième contact (254) est relié à la deuxième piste (118) conductrice et le troisième contact (256) est relié à l'électrode (122) de détection et est réalisé sous la forme de l'électrode (122) de détection.

9. Ensemble (102) circuit suivant l'une des revendications précédentes, dans lequel le dispositif (112) de détection est constitué pour, en utilisant le signal (130) de détection, disposer d'un signal (136) de mise hors circuit pour mettre l'unité (114) hors circuit et/ou d'un signal (138) de passage pour faire passer un système (104) comprenant l'ensemble (102) circuit dans un état sécurisé ou donner un signal (140) d'alerte.

10. Ensemble (102) circuit suivant l'une des revendications précédentes, dans lequel le dispositif (112) de détection est constitué pour déterminer une variation en fonction du temps du signal appliqué à l'électrode (122) de détection et pour mettre à disposition le signal (130) de détection en utilisant la variation en fonction du temps.

11. Ensemble (102) circuit suivant l'une des revendications précédentes, dans lequel le dispositif (112) de détection est constitué pour, en utilisant un signal appliqué à l'électrode (122) de détection, déterminer une valeur de résistance électrique entre la première piste (116) conductrice et la deuxième piste (118) conductrice et déterminer le signal (130) de détection en utilisant la valeur de la résistance.

12. Ensemble (102) circuit suivant l'une des revendications précédentes, qui a un coulisseau (360) mobile, et dans lequel le circuit (112) de fonctionnement est constitué, en utilisant un signal de fonctionnement transmis par la première piste (116) conductrice et la deuxième piste (118) conductrice, disposer d'un signal (132) de position représentant une position du coulisseau (360) mobile.

13. Procédé pour faire fonctionner un ensemble (102) circuit suivant l'une des revendications précédentes, dans lequel le procédé comprend les stades suivants :
on transmet (580) un signal de fonctionnement par la première piste (116) conductrice et la deuxième piste (118) conductrice ;
on analyse (582) le signal appliqué à l'électrode (122) de détection, afin de détecter le courant (124) de fuite et de disposer d'un signal (130) de détection représentant le courant (124) de fuite ;
**caractérisé par** un stade de
mise à disposition d'un signal (134) de correction en utilisant le signal (130) de détection, afin de corriger un signal transmis par la première piste (116) conductrice et/ou la deuxième piste (118) conductrice et faussé par le courant (124) de fuite.
